(19) Europäisches Patentamt
European Patent Office
Office européen des brevets

(11) **EP 2 082 400 B1**

(12) **FASCICULE DE BREVET EUROPEEN**

(45) Date de publication et mention
de la délivrance du brevet:
**19.09.2012 Bulletin 2012/38**

(21) Numéro de dépôt: **07858622.9**

(22) Date de dépôt: **19.10.2007**

(51) Int Cl.:
***G11C 11/16*** (2006.01)

(86) Numéro de dépôt international:
**PCT/FR2007/052199**

(87) Numéro de publication internationale:
**WO 2008/050045 (02.05.2008 Gazette 2008/18)**

(54) **DISPOSITIF MAGNETIQUE A AIMANTATION PERPENDICULAIRE ET A COUCHE INTERCALAIRE COMPENSATRICE D'INTERACTIONS**

MAGNETVORRICHTUNG MIT PENDELMAGNETISIERUNG UND EINER INTERAKTIONSAUSGLEICHENDEN ZWISCHENSCHICHT

MAGNETIC DEVICE WITH PERPENDICULAR MAGNETISATION AND COMPRISING AN INTERACTION-COMPENSATING INTERMEDIATE LAYER

(84) Etats contractants désignés:
**AT BE BG CH CY CZ DE DK EE ES FI FR GB GR HU IE IS IT LI LT LU LV MC MT NL PL PT RO SE SI SK TR**

(30) Priorité: **23.10.2006 FR 0654448**

(43) Date de publication de la demande:
**29.07.2009 Bulletin 2009/31**

(73) Titulaires:
- **Commissariat à l'Énergie Atomique et aux Énergies Alternatives**
  **75015 Paris (FR)**
- **Centre National de la Recherche Scientifique**
  **75794 Paris Cedex 16 (FR)**

(72) Inventeurs:
- **RODMACQ, Bernard**
  **38113 Veurey Voroize (FR)**

- **BALTZ, Vincent**
  **33200 Bordeaux (FR)**
- **BOLLERO, Alberto**
  **25022 Madrid (ES)**
- **DIENY, Bernard**
  **38250 Lans en Vercors (FR)**

(74) Mandataire: **Vuillermoz, Bruno et al**
**Cabinet Laurent & Charras**
**"Le Contemporain"**
**50, Chemin de la Bruyère**
**69574 Dardilly Cédex (FR)**

(56) Documents cités:
**EP-A2- 0 933 782      JP-A- 8 321 016**
**US-B2- 6 754 054**

## Description

## DOMAINE DE L'INVENTION

La présente invention se rapporte au domaine des microstructures à propriétés magnétiques. Elle a trait à un dispositif magnétique comprenant des couches magnétiques minces à aimantation perpendiculaire au plan desdites couches et une couche intercalaire non magnétique séparant ces couches magnétiques.

Ses applications potentielles concernent les mémoires de stockage magnétique à champs multi-coercitif, ou les mémoires magnétiques à accès aléatoire (MRAM), ou les portes logiques reprogrammables, ou encore les vannes de spin électroniques ou jonctions tunnel magnétiques incluant un dispositif magnétique conforme à l'invention.

## ETAT ANTERIEUR DE LA TECHNIQUE

Dans le domaine des mémoires et des supports d'enregistrement magnétiques, il est connu d'employer des dispositifs magnétiques comportant au moins deux couches réalisées en un matériau magnétique, séparées par une couche intercalaire réalisée en un matériau non magnétique. En général, ces différentes couches et leurs interfaces sont globalement planes et parallèles entre elles.

Pour augmenter les capacités de tels dispositifs magnétiques, on cherche à rendre les structures de ces mémoires de plus en plus compactes. Pour cela, les dispositifs magnétiques mettent en oeuvre des couches ferromagnétiques, dont les dimensions sont de plus en plus petites. En particulier, ces couches sont de plus en plus minces et les empilements formant les dispositifs magnétiques sont de plus en plus étroits et courts.

Par définition, l'épaisseur d'une couche, ou sa minceur, est définie perpendiculairement à la direction d'empilement des différentes couches, tandis que la largeur ou la longueur, respectivement de plus en plus étroites et courtes, sont définies selon les dimensions latérales, c'est-à-dire prises dans un plan parallèle au plan des couches, et donc perpendiculaire à la direction d'empilement.

Dans le cadre de l'application aux supports d'enregistrement ou aux mémoires magnétiques, il est important que chacune des couches magnétiques empilées soit magnétiquement indépendante des autres couches magnétiques.

Dans le cas où le dispositif magnétique possède des couches de grandes dimensions latérales, les interactions magnétiques entre les différentes couches constituant l'empilement, dues au champ magnétique rayonné par chacune des couches magnétiques, demeurent négligeables.

Cependant, lorsque la structure magnétique est obtenue par dépôt en phase vapeur (techniques dites de PVD, comme par exemple la pulvérisation cathodique), des charges magnétostatiques peuvent apparaître et s'accumuler au niveau des interfaces entre la couche intercalaire non magnétique et chacune des couches magnétiques. Ces charges magnétostatiques s'avèrent d'autant plus nombreuses que la rugosité des interfaces est importante.

En particulier, lorsque l'épaisseur de la couche non magnétique est constante mais avec une position moyenne variable selon la direction de l'empilement des couches, la couche intercalaire présente alors une section en forme de « tôle ondulée ». On parle dans ce cas de rugosité corrélée. Avec une telle topologie de la couche intercalaire, les charges magnétiques ainsi apparues induisent un champ de couplage magnétique entre les couches magnétiques situées de part et d'autre de la couche intercalaire non magnétique.

Dans le cas des couches magnétiques à aimantation planaire, il est connu que ce champ de couplage tend à aligner parallèlement les aimantations des couches magnétiques. Les couches magnétiques situées de part et d'autre de la couche intercalaire non magnétique ne sont alors plus magnétiquement indépendantes l'une de l'autre ou les unes des autres lorsqu'elles sont multiples. Ce couplage est généralement appelé "couplage de Néel" ou "couplage peau d'orange" (en anglais "Orange Peel coupling"), et ne dépend pas, en première approximation, des dimensions latérales de l'empilement.

D'autre part, lorsque l'on miniaturise le dispositif magnétique en réduisant les dimensions latérales de l'empilement jusqu'à quelques dizaines ou centaines de nanomètres, les champs rayonnés par chacune des couches ferromagnétiques, toujours supposées avoir une aimantation planaire, engendrent une interaction magnétostatique entre ces couches.

Par analogie avec deux barreaux aimantés qui s'attirent lorsqu'on les rapproche l'un de l'autre, le pôle sud du premier barreau vient préférentiellement en regard du pôle nord du deuxième barreau, et réciproquement, comme cela est représenté schématiquement sur la figure la. Cette interaction magnétostatique tend donc à orienter antiparallèlement les aimantations des couches magnétiques.

Par conséquent, les effets de cette interaction magnétostatique, dont la force dépend des dimensions latérales de l'empilement, s'opposent aux effets du champ de couplage dû à la corrélation des rugosités de la couche intercalaire, de part les signes opposés des champs magnétostatiques respectivement crées.

Ainsi, il est possible, par un ajustement judicieux de l'intensité de ces deux effets, en modifiant par exemple intentionnellement la rugosité de la couche intercalaire, de réaliser un support d'enregistrement magnétique relativement compact, dont les couches magnétiques sont quasiment magnétiquement indépendantes les unes des autres. Les documents US-B-6 727 105 et US-A-2004/013880 décrivent des supports d'enregistrement magnétique ainsi constitués, pour lesquels les effets magnétiques indésirables se compensent mutuellement.

En revanche, comme l'expose le document FR-A-2 859 306, la miniaturisation des supports magnétiques à aimantation planaire se heurte à une limite qui complique ou empêche l'écriture d'informations par les têtes d'écriture actuellement disponibles. Il s'agit de la limite superparamagnétique, c'est-à-dire la limite correspondant à des tailles latérales au dessous desquelles l'aimantation du système n'arrive plus à rester stable typiquement pendant une période de dix ans à température ambiante.

Or, comme l'indique ce document FR-A-2 859 306, les dispositifs magnétiques dont les couches présentent une aimantation à orientation perpendiculaire présentent une limite superparamagnétique qui est repoussée vers les plus petites tailles, car le champ de démagnétisation diminue avec la miniaturisation du dispositif magnétique.

De plus, les têtes d'écriture sont actuellement plus efficaces en terme d'amplitude de champ délivré et de résolution spatiale pour réaliser des enregistrements perpendiculaires que pour les enregistrements planaires. C'est pourquoi on cherche actuellement à développer des supports d'enregistrement dont les couches possèdent une aimantation perpendiculaire au plan desdites couches magnétiques.

De la même façon que les dispositifs à aimantation planaire, les dispositifs à aimantation perpendiculaire au plan des couches magnétiques subissent également une interaction ferromagnétique liée à la rugosité corrélée de la couche intercalaire. Cette interaction ferromagnétique engendre donc un champ de couplage ferromagnétique entre les couches magnétiques situées de part et d'autre de la couche intercalaire non magnétique.

Dans le cas où le dispositif à aimantation perpendiculaire possède de grandes dimensions latérales, les champs rayonnés par les couches magnétiques situées d'un côté de la couche intercalaire exercent une interaction négligeable sur les couches magnétiques situées de l'autre côté. Néanmoins, et comme pour les dispositifs magnétiques à aimantation planaire, lorsque l'on réduit les dimensions latérales de l'empilement des couches, le champ rayonné par une couche magnétique exerce alors une interaction magnétostatique non négligeable sur les autres couches magnétiques.

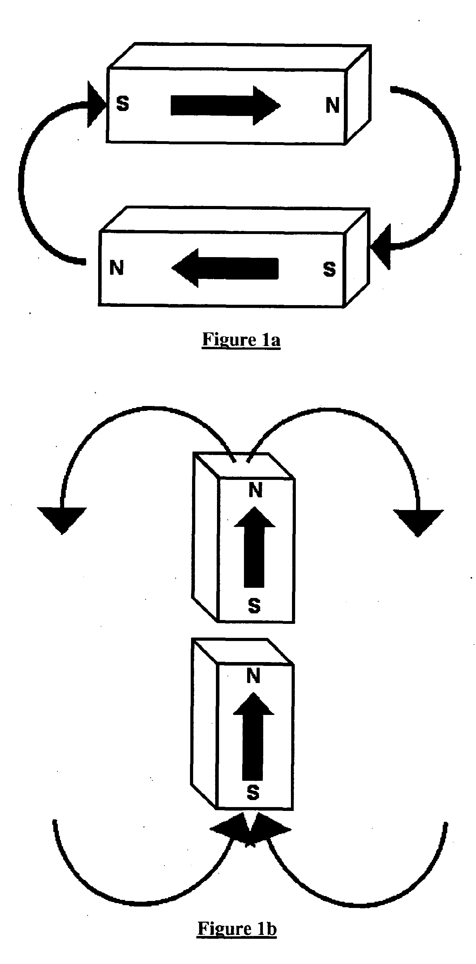

En revanche, à la différence des dispositifs à aimantation planaire, le champ de couplage dû à cette interaction magnétostatique n'est pas antiferromagnétique mais ferromagnétique, comme cela est illustré schématiquement sur la figure 1b. Par conséquent, l'interaction de rugosité (couplage "peau d'orange") et l'interaction magnétostatique ne se compensent plus, mais au contraire s'ajoutent, si bien que les couches magnétiques situées de part et d'autre de la couche intercalaire ne peuvent plus être rendues magnétiquement indépendantes par une compensation entre ces deux formes de couplage.

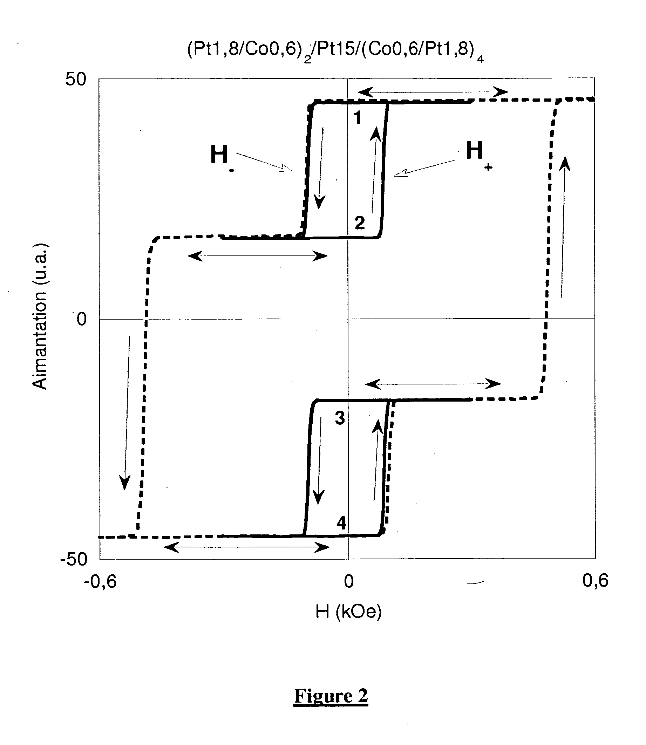

La figure 2 représente ainsi les cycles d'hystérésis ou courbes d'aimantation de deux structures à multicouches magnétiques possédant de grandes dimensions latérales, c'est-à-dire n'exerçant quasiment pas d'interaction magnétostatique l'une sur l'autre.

En l'occurrence l'empilement formant le dispositif magnétique comprend deux multicouches de cobalt et de platine superposées, séparées par une couche intercalaire non magnétique épaisse en platine, selon la formule $(Pt_{1,8}/Co_{0,6})_2/Pt_{15}/(Co_{0,6}/Pt_{1,8})_4$. Les nombres 1,8, 0,6 et 15 désignent les épaisseurs en nanomètres des couches chimiquement homogènes (désignées par leurs éléments chimiques) auxquels ils sont accolés. Les indices 2 et 4 désignent quant à eux le nombre de répétitions du motif (Co/Pt) ou (Pt/Co) des multicouches placées de part et d'autre de la couche intercalaire.

Pour cet empilement, et compte tenu de la faible épaisseur des couches utilisées (dans cet exemple 1,8 et 0,6 nanomètres pour le platine et le cobalt), chaque multicouche peut être considérée comme une couche magnétiquement homogène. L'utilisation de ces multicouches permet de faire que les aimantations de chacune d'elle soit perpendiculaire au plan des couches, ce qui ne serait pas le cas par exemple dans le cas d'une couche de cobalt put.

Ces multicouches (Co/Pt), qui pourraient être remplacées par tout autre matériau, alliage ou multicouche possédant également la propriété d'aimantation perpendiculaire au plan, ne sont utilisées ici qu'à titre d'illustration des phénomènes physiques mis en jeu. Par exemple des multicouches (Co/Pd) ou des alliages chimiquement ordonnés FePt ou FePd pourraient être aussi utilisés. Chacune des deux multicouches sera donc dénommée "couche magnétique" dans la suite.

De la même façon, la nature de la couche intercalaire n'est pas limitée au platine, et tout autre matériau, alliage ou multicouche non magnétique pourrait être utilisé pour autant que cette couche intercalaire préserve l'intégrité structurale de l'empilement et l'orientation des aimantations des différentes couches magnétiques perpendiculairement à leur plan. Son épaisseur, fonction du matériau utilisé, sera choisie afin que l'éventuel couplage magnétique entre les deux couches magnétiques à travers cette couche intercalaire soit beaucoup moins intense que le couplage entre les couches de cobalt à l'intérieur de chaque multicouche.

Sur les cycles représentés sur la figure 2, les flèches indiquent le sens de parcours du cycle magnétique lorsque l'on applique l'excitation magnétique **H** indiquée en abscisse. Les flèches monodirectionnelles représentent les évolutions irréversibles des cycles, tandis que les flèches bidirectionnelles représentent leurs évolutions réversibles. En ordonnée, les niveaux d'aimantation sont donnés en unités arbitraires.

Les courbes en traits pointillés correspondent à un cycle d'hystérésis dit "majeur", c'est-à-dire pour lequel l'amplitude de variation du champ d'excitation magnétique est suffisante pour inverser successivement la direction d'aimantation des deux couches magnétiques, tandis que les courbes représentées en trait continu correspondent à un cycle dit "mineur", dans lequel l'amplitude, plus faible, du champ magnétique appliqué ne conduit qu'au seul renversement de la couche magnétique la plus douce.

La "dureté" (ou "douceur") magnétique se définit par rapport à la valeur du champ magnétique, dénommé champ coercitif, nécessaire au renversement de l'aimantation de chacune des couches magnétiques. Telle couche magnétique sera donc réputée plus "dure" si son champ coercitif est plus élevé.

Si on dénote par $H_+$ et $H_-$ les champs de renversement de la couche magnétique la plus douce pour des champs magnétiques appliqués respectivement croissants et décroissants (voir figure 2), la valeur du champ coercitif de cette couche sera donnée par:

$$H_{c1} = |H_+ - H_-|/2$$

où les symboles | | dénote la valeur absolue de la différence des champs de renversement. Les points **1** et **2** sur la figure 2 correspondent au cas où l'aimantation de la couche la plus "dure" est vers le haut (aimantation positive), alors que celle de la couche magnétique la plus "douce" est, soit vers le haut, soit vers le bas.

D'une façon analogue, les points **3** et **4** correspondent au cas où l'aimantation de la couche la plus "dure" est dirigée vers le bas (aimantation négative), alors que celle de la couche magnétique la plus "douce" est dirigée, soit vers le haut, soit vers le bas. La détermination du champ coercitif de la couche magnétique la plus douce peut donc comme ci-dessus également se faire lorsque l'aimantation de la couche magnétique la plus "dure" est négative.

Si le cycle "mineur" est symétrique par rapport au champ magnétique nul, on aura $|H_+| = |H_-|$, signe d'indépendance magnétique des deux couches. Par contre, un décalage du cycle dit "mineur" par rapport au champ magnétique nul traduira une interaction entre les deux couches magnétiques à travers la couche intercalaire non magnétique, ce décalage pouvant être soit vers les champs positifs, soit vers les champs négatifs selon le signe de l'interaction.

Avec les mêmes définitions que celles utilisées précédemment, ce champ de couplage entre les deux couches magnétiques $H_{cpl}$ pourra être calculé suivant:

$$H_{cpl} = (H_+ + H_-)/2$$

L'interaction sera dénommée ferromagnétique si $H_{cpl}$ est négatif (aimantations parallèles), et antiferromagnétique si $H_{cpl}$ est positif (aimantations antiparallèles).

On constate sur la figure 2 que le cycle d'hystérésis de la couche magnétique la plus douce est quasiment centré par rapport aux champs d'excitation magnétique nuls (**H = 0 kOe**). Le léger décalage observé, de 5 Oe vers les champs négatifs, indique la présence d'une légère rugosité des interfaces, tendant à stabiliser une orientation parallèle des aimantations des deux couches, ainsi qu'il a été signalé précédemment. Si on néglige ce faible couplage ferromagnétique, comparé aux valeurs des champs coercitifs, les deux couches magnétiques de part et d'autre de la couche intercalaire sont donc essentiellement magnétiquement indépendantes l'une de l'autre.

De manière connue, dans le cas par exemple d'application à des dispositifs de type "mémoires de stockage", lorsque l'on met en oeuvre deux couches de dureté magnétiques différentes de part et d'autre de la couche intercalaire, on détermine quatre états stables en champ d'excitation nul, ce qui permet de doubler la quantité d'informations stockées par rapport au cas où l'on n'utilise qu'une seule couche magnétique, qui ne possède que deux états stables en champ nul.

La couche intercalaire qui sépare les couches magnétiques, constituée ici de platine, est relativement épaisse puisqu'elle mesure 15 nm. Les compositions de chaque multicouches de cobalt et de platine (épaisseurs des couches ou nombre de répétitions du motif élémentaire Co/Pt) conduisent à des valeurs très différentes des champs coercitifs $H_{c1}$ et $H_{c2}$ des deux couches magnétiques.

Comme exposé précédemment, les interactions magnétostatiques entre les couches magnétiques sont négligeables dans ce cas, puisque les dimensions latérales de l'empilement sont grandes et que la couche intercalaire est épaisse. Il ne subsiste que la faible contribution due à la rugosité des interfaces.

Un dispositif magnétique composé de couches à aimantation perpendiculaire, tel que défini ci-dessus, présente donc quatre états magnétiques stables en champ magnétique nul, c'est-à-dire lorsque aucun champ magnétique n'est appliqué au dispositif. Ces quatre états magnétiques sont respectivement les états haut-haut, haut-bas, bas-haut et bas-bas et ils correspondent aux points **1, 2, 3** et **4** de la figure 2.

Si on dénote par $M_1$ et $M_2$ les aimantations de chacune des deux couches magnétiques, $M_2$ désignant par exemple l'aimantation de la couche la plus dure magnétiquement, l'aimantation résultante correspondant à chacun de ces états sera ($M_2 + M_1$), ($M_2 - M_1$), (- $M_2$ + $M_1$) et (- $M_2$ - $M_1$), pour les états **1, 2, 3** et **4** de la figure 2. On constate que seulement 3 états distincts seront possible lorsque $M_2 = M_1$, puisque dans ce cas les états **2** et **3** seront équivalents en terme d'aimantation totale.

Pour atteindre chacun de ces quatre états stables, quand $M_1$ est différent de $M_2$, il faut soumettre le dispositif magnétique aux séquences de champs d'excitation magnétique suivantes (les valeurs numériques citées correspondent au cas envisagé à la figure 2, et dépendent évidemment des valeurs des champs coercitifs $H_{c1}$ et $H_{c2}$ des deux couches magnétiques, et donc de la structure particulière de chacune des couches magnétiques) :

- pour l'état **1, H**= +0,6kOe, puis **H**= 0 kOe ;
- pour l'état **2, H**= +0,6kOe, puis **H**= -0,3kOe et enfin **H**= OkOe ;
- pour l'état **3, H**= -0,6kOe, puis **H**= +0,3kOe et enfin **H**= OkOe ;
- pour l'état **4, H**= -0,6kOe, puis **H**= 0 kOe ;

La discussion précédente était basée sur un type d'application dit "stockage magnétique multicoercitif', dans lequel les quatre états d'aimantation distincts permettent de doubler la densité d'information stockée par rapport à une mémoire classique comportant une seule couche magnétique et ne possédant donc que deux états d'aimantation (vers le haut ou vers le bas).

Dans un autre type d'application, par exemple les mémoires magnétiques non volatiles ou les portes logiques reprogrammables, on utilise des empilements de couches du type "jonction tunnel magnétique", ou "vanne de spin", également constitués de deux couches magnétiques séparées par une couche non magnétique, métallique ou isolante, ayant pour but d'assurer l'indépendance magnétique des deux couches magnétiques.

Dans ce cas, la lecture de l'état de la mémoire se fait en mesurant sa résistance électrique, par circulation d'un courant électrique dans une direction perpendiculaire au plan des couches. Cette résistance électrique est plus élevée lorsque les aimantations des deux couches sont antiparallèles que dans le cas où elles sont parallèles. Ce phénomène, dit de "magnétorésistance géante" si la couche non magnétique séparatrice est métallique, ou dit de "magnétorésistance tunnel" si la couche non magnétique séparatrice est isolante, et bien connu dans la littérature, ne dépend donc que de l'orientation relative des aimantations des deux couches.

Par référence à la figure 2, les états **1** et **4** sont donc indiscernables, de même que les états **2** et **3**, puisqu'ils correspondent à la même orientation relative des aimantations (parallèles pour les états **1** et **4,** antiparallèles pour les états **2** et **3**). Ces états seront dénommés "états dégénérés". Dans toute application où le signal utile est la résistance électrique de l'empilement (ex. : mémoires magnétiques, porte logique), l'information utilisée n'est pas le nombre d'états magnétiques mais seulement le nombre, deux fois moins élevé, d'états dégénérés.

Il n'en reste pas moins vrai que, pour que cette mémoire ou porte logique soit fonctionnelle, il est tout autant nécessaire que les deux états dégénérés (**1, 4**) et (**2, 3**), correspondant à des directions d'aimantation respectivement parallèles et antiparallèles des deux couches magnétiques, soient tous deux stables en champ magnétique nul, c'est-à-dire lorsque le dispositif n'est soumis à aucun champ magnétique extérieur. Par rapport à la discussion précédente, il est donc nécessaire que le champ de couplage entre couches soit strictement inférieur au champ coercitif de la couche magnétique la plus "douce".

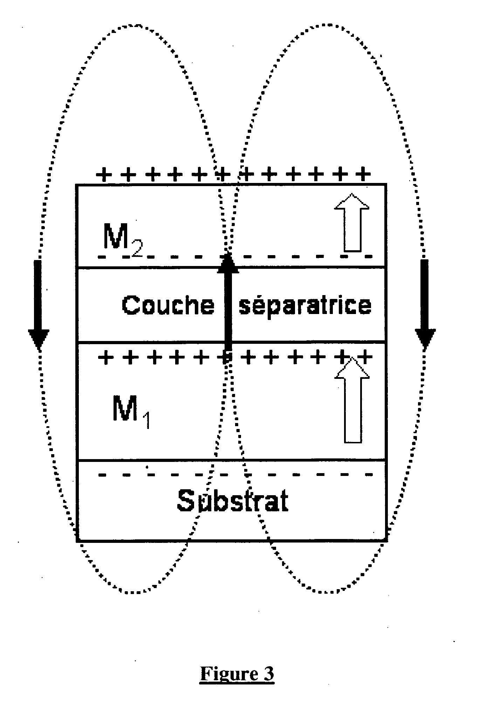

La figure 3 est une représentation schématique de deux couches magnétiques à aimantation perpendiculaire au plan, séparées par une couche non magnétique. $M_1$ et $M_2$ désignent les aimantations des deux couches, les flèches transparentes représentent la direction des aimantations de ces couches, et les flèches pleines schématisent les champs magnétiques rayonnés d'une couche sur l'autre, tendant à aligner parallèlement les aimantations des deux couches magnétiques. Par réduction des dimensions latérales, les charges magnétostatiques positives et négatives apparaissant aux interfaces des couches magnétiques donnent naissance à un couplage magnétostatique favorisant l'alignement parallèle des aimantations des deux couches magnétiques.

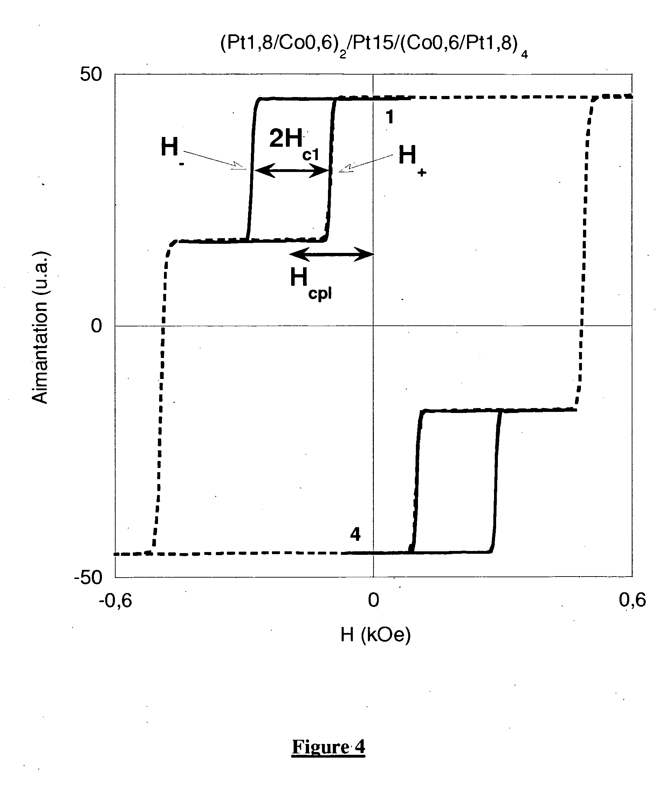

La figure 4 illustre l'effet, sur la courbe de variation de l'aimantation en fonction du champ magnétique appliqué, de la réduction des dimensions latérales d'un dispositif magnétique tel que celui décrit en relation avec la figure 3. Dans ce cas, comme cela est exposé ci-dessus, il apparaît un champ de couplage de type ferromagnétique entre les couches magnétiques situées de part et d'autre de la couche intercalaire sous l'effet des interactions magnétostatiques.

Par conséquent, comme le montre la figure 4, la courbe d'aimantation de la couche magnétique la plus douce (en trait continu) se décale par rapport au champ magnétique nul le long de l'axe des abscisses, et vers les champs magnétiques négatifs. Les aimantations des deux couches tendent à rester parallèles l'une à l'autre le plus longtemps possible sous l'effet de ce couplage ferromagnétique. Il sera alors nécessaire d'appliquer un champ magnétique **H** d'amplitude supérieure au cas de la figure 2 (en fait la somme du champ coercitif $H_{c1}$ et du champ de couplage $H_{cpl}$) afin de renverser l'aimantation de la couche douce.

De plus, si le champ de couplage ferromagnétique provoquant ce décalage est supérieur au champ coercitif $H_{cl}$ de la couche magnétique la plus douce, ce qui est le cas représenté sur la figure 3, les états intermédiaires haut-bas et bas-haut (points **2** et **3** de la figure 2) ne seront plus stables en champ magnétique nul. Ainsi comme cela ressort de la figure 4, seuls les deux états extrêmes haut-haut et bas-bas, correspondant respectivement aux points **1** et **4**, sont susceptibles d'être stables une fois que l'on a cessé de soumettre le dispositif magnétique à un champ d'excitation, tel que celui généré par une tête d'écriture.

En conséquence, avec un tel support d'enregistrement magnétique, la quantité d'informations enregistrables est divisée par deux par rapport au dispositif décrit en relation avec la figure 2.

Un tel empilement ayant deux états magnétiques stables en champ nul (haut-haut et bas-bas) correspondant tous deux à la même orientation relative des aimantations des deux couches magnétiques, son application à un dispositif comme les mémoires non volatiles ou les portes logiques ne sera pas fonctionnelle, puisque le seul état stable en champ magnétique nul sera un état dégénéré correspondant au cas où les aimantations sont parallèles (état de basse résistance).

Il sera toujours possible d'accéder à l'état antiparallèle (haute résistance) par une impulsion de champ magnétique, mais cet état ne sera pas conservé lorsque l'impulsion de champ magnétique sera terminée, et la propriété de non volatilité sera perdue.

## EXPOSE DE L'INVENTION

La présente invention selon la revendication 1 a donc pour objectif de proposer un dispositif magnétique dont les couches magnétiques présentent une aimantation perpendiculaire au plan de ces couches et où le champ de couplage entre ces couches magnétiques situées de part et d'autre d'une couche non magnétique demeure plus faible que le champ coercitif de la couche magnétique la plus douce.

La présente invention selon la revendication 1 concerne donc un dispositif magnétique comportant au moins deux couches en matériaux magnétiques séparées par au moins une couche intercalaire en matériau non magnétique.

Selon l'invention, les couches en matériaux magnétiques présentent chacune une aimantation orientée sensiblement perpendiculairement au plan des couches. De plus, la couche en matériau non magnétique est apte à induire, suivant le matériau considéré et son épaisseur, un champ de couplage antiferromagnétique entre ces couches en matériaux magnétiques, de façon à atténuer les effets du champ de couplage ferromagnétique qui s'exerce entre elles lorsqu'il existe une certaine rugosité des interfaces de part et d'autre de la couche séparatrice et/ou lorsque les dimensions latérales du dispositif sont réduites.

En d'autres termes, les effets de ce couplage antiferromagnétique s'opposent aux interactions ferromagnétiques qui s'exercent entre les couches magnétiques. Ainsi, ce champ de couplage supplémentaire, si son amplitude est bien choisie, rend les couches en matériau magnétique situées de part et d'autre de la couche intercalaire quasi-indépendantes magnétiquement les unes des autres, voire indépendantes. Il se produit donc une compensation entre interactions magnétiques.

En pratique, la couche intercalaire mise en oeuvre est constituée d'un matériau choisi parmi le ruthénium (Ru), le chrome (Cr), l'or (Au), l'argent (Ag), le vanadium (V), le niobium (Nb), ou encore d'un alliage isolant choisi parmi les oxydes de silicium, de magnésium, de zirconium, de titane, de tantale, de chrome, de ruthénium ou d'aluminium.

La couche intercalaire mise en oeuvre présente une épaisseur comprise entre 0,2 nm et 10 nm.

Par épaisseur, on entend la dimension prise dans le sens d'empilement des différentes couches, c'est-à-dire selon la direction perpendiculaire au plan des couches. Une couche intercalaire ainsi structurée favorise l'apparition d'un couplage antiferromagnétique susceptible de compenser tout ou partie du couplage ferromagnétique apparaissant entre les couches magnétiques situées de part et d'autre d'une telle couche intercalaire.

En pratique, lorsque les dimensions latérales de ce dispositif magnétique, définies dans un plan parallèle au plan des couches, sont typiquement inférieures à 10 $\mu$m, le champ de couplage ferromagnétique s'exerçant entre couches magnétiques est relativement intense, mais il peut être compensé par le champ de couplage antiferromagnétique induit à travers la couche intercalaire en matériau non magnétique.

Selon une forme de réalisation de l'invention, la résultante des champs de couplage ferromagnétique et antiferromagnétique peut être moins intense que le champ coercitif de la couche magnétique la plus douce.

En d'autres termes, les courbes d'aimantation des couches magnétiques dure et douce ne sont pas trop décalées, si bien que le dispositif magnétique présente toujours quatre états stables lorsqu'il est soumis à un champ d'excitation magnétique nul.

De manière pratique, l'intensité du champ de couplage antiferromagnétique peut compenser au moins partiellement l'intensité du champ de couplage ferromagnétique résultant des interactions magnétostatiques entre couches en matériaux magnétiques ainsi que des interactions ferromagnétiques survenant au niveau desdites interfaces, de façon à ce que la résultante de ces champs de couplage soit plus faible que le champ coercitif de la couche magnétique douce.

On réalise ainsi une compensation mutuelle au moins partielle entre les effets produits par les différents champs, interactions dues aux rugosités d'une part et à la petitesse des dimensions latérales d'autre part. Le couplage antiferromagnétique ainsi déterminé permet d'atténuer sensiblement les effets du couplage ferromagnétique dû aux interactions entre couches magnétiques, et de rendre stable, en l'absence de champ magnétique extérieur, les deux états d'orientation relative des aimantations, parallèles et antiparallèles.

Selon une autre forme de réalisation pratique de l'invention, l'intensité et l'orientation de ce champ de couplage antiferromagnétique peuvent compenser quasi-exactement l'intensité du champ de couplage ferromagnétique résultant des interactions magnétostatiques, le champ de couplage résultant de ces compensations étant au moins dix fois plus faible que le champ coercitif de la couche magnétique douce.

Le couplage antiferromagnétique ainsi déterminé permet d'annuler les effets du couplage ferromagnétique entre couches magnétiques, ce qui rend complètement indépendantes magnétiquement les couches magnétiques situées de part et d'autre de la couche intercalaire non magnétique.

Selon une forme de réalisation particulière de l'invention, les couches en matériau magnétique peuvent être composées d'une pluralité de couches, formées d'une part d'un alliage constitué d'un matériau choisi parmi le fer, le cobalt et le nickel, et d'autre part, d'un matériau choisi parmi le platine, le palladium, le cuivre, ou d'un ou plusieurs élément appartenant au groupe des terres rares ou au groupe des métaux de transition magnétiques, de manière à présenter des aimantations orientées sensiblement perpendiculairement au plan des couches.

Des couches magnétiques ainsi structurées présentent des champs coercitifs suffisamment faibles pour que le dispositif magnétique soit sensible à des champs d'excitation magnétique couramment réalisables, mais également suffisamment élevés pour présenter des états stables pour des champs d'excitation magnétique faibles ou nuls.

En pratique, une couche supplémentaire peut être insérée entre la couche intercalaire et l'une au moins des couches en matériaux magnétiques, cette couche étant mince, typiquement d'une épaisseur inférieure à 1 nanomètre, et étant constituée d'un matériau tel que le platine ou le palladium, apte à renforcer l'anisotropie magnétique perpendiculaire desdites couches en matériau magnétique.

Selon une forme de réalisation particulière de l'invention, le dispositif magnétique peut comprendre des multicouches formées respectivement par quatre couches et deux couches en matériaux magnétiques de part et d'autre de ladite couche en matériau non magnétique, les couches magnétiques présentant des duretés magnétiques différentes, de telle sorte que les aimantations rémanentes de ces couches en matériaux magnétiques présentent quatre états stables en champ d'excitation magnétique nul, respectivement haut-haut, haut-bas, bas-haut, bas-bas.

Un tel dispositif magnétique présente donc au moins quatre états stables en champ d'excitation magnétique nul, car les multicouches magnétiques situées de part et d'autre de la couche intercalaire non magnétique sont mutuellement indépendantes magnétiquement.

Selon une forme de réalisation pratique de cette forme de réalisation particulière de l'invention, les couches successives du dispositif magnétiques peuvent être constituées :

- d'une alternance de quatre couches de 1,8 nm de platine associées à quatre couches de 0,6 nm de cobalt,
- d'une couche non magnétique de 1 nm de ruthénium,
- d'une alternance de deux couches de 0,6 nm de cobalt associées à deux couches de 1,8 nm de platine.

Par ailleurs, la présente invention concerne une mémoire magnétique à accès aléatoire, un support d'enregistrement magnétique à champ multi-coercitif, ou une porte logique reprogrammable, comprenant un dispositif magnétique tel qu'exposé ci-dessus.

De tels dispositifs peuvent donc présenter une grande compacité qui permet leur miniaturisation par rapport aux dispositifs analogues de l'art antérieur, sans que leur fonctionnement ne soit perturbé par les champs magnétostatiques résultant de cette réduction de taille ou de la rugosité corrélée des interfaces. De plus, les états stables des cycles d'aimantation des couches magnétiques présentent une stabilité renforcée, ce qui rend ces dispositifs moins sensibles aux perturbations magnétiques usuelles.

## BREVE DESCRIPTION DES DESSINS

La manière dont l'invention peut être réalisée et les avantages qui en découlent ressortiront aussi des exemples de réalisation qui suivent, donnés à titre indicatif et non limitatif à l'appui des figures annexées, parmi lesquelles :

La figure 1 est une représentation schématique des interactions entre deux barreaux aimantés. Cette figure a déjà été décrite en relation avec l'état antérieur de la technique.

La figure 2 est une représentation schématique des courbes d'aimantation d'un dispositif magnétique de l'art antérieur. Cette figure a également déjà été décrite en relation avec l'état antérieur de la technique.

La figure 3 est une représentation schématique de l'empilement de deux couches magnétiques séparées par une couche intercalaire non magnétique. Cette figure a également déjà été décrite en relation avec l'état antérieur de la technique.

La figure 4 est une représentation schématique des courbes d'aimantation d'un dispositif magnétique de l'art antérieur. Cette figure a également déjà été décrite en relation avec l'état antérieur de la technique.

La figure 5 est une représentation schématique des courbes d'aimantation d'un dispositif magnétique présentant de grandes dimensions latérales.

La figure 6 est une représentation schématique des courbes d'aimantation d'un dispositif magnétique conforme à la présente invention.

La figure 7 est une représentation schématique d'un ensemble de 6 cellules MRAM conforme à la présente invention.

La figure 8 représente un diagramme illustrant l'évolution du champ rayonné par la couche magnétiquement dure sur la couche magnétiquement douce en fonction de l'épaisseur de la couche intercalaire non magnétique.

## MODE DE REALISATION DE L'INVENTION

Parmi les interactions magnétiques évoquées ci-dessus, les recherches ont mis notamment en évidence un type de couplage survenant entre deux couches magnétiques minces séparées par une couche intercalaire métallique non magnétique *(Systematic variation of the strength and oscillation period of indirect magnetic exchange coupling through the 3d, 4d, and 5d transition metals, S. S. P. Parkin et al, Physical Review Letters 67, 3598-3601 (1991))*. Il s'agit du couplage RKKY (d'après le nom des chercheurs Ruderman, Kittel, Kasuya et Yosida).

Or, ce couplage RKKY est susceptible de favoriser un alignement parallèle ou un alignement antiparallèle des aimantations des couches magnétiques situées de part et d'autre de la couche intercalaire suivant la nature et l'épaisseur de cette dernière. Ainsi l'alignement de ces aimantations est déterminé par la nature du matériau métallique non magnétique et par son épaisseur, laquelle doit néanmoins demeurer faible. De plus, ce couplage RKKY est essentiellement indépendant des dimensions latérales de l'empilement de couches.

Un autre type de couplage indirect antiferromagnétique a également été mis en évidence pour une couche séparatrice à base d'oxyde métallique. C'est le cas notamment de jonctions tunnel magnétiques à base d'oxyde de magnésium MgO *(Interlayer magnetic coupling interactions of two ferromagnetic layers by spin polarized tunneling, J. Faure-Vincent et al, Physical Review Letters, vol. 89, n° 10, 107206 (2002))*.

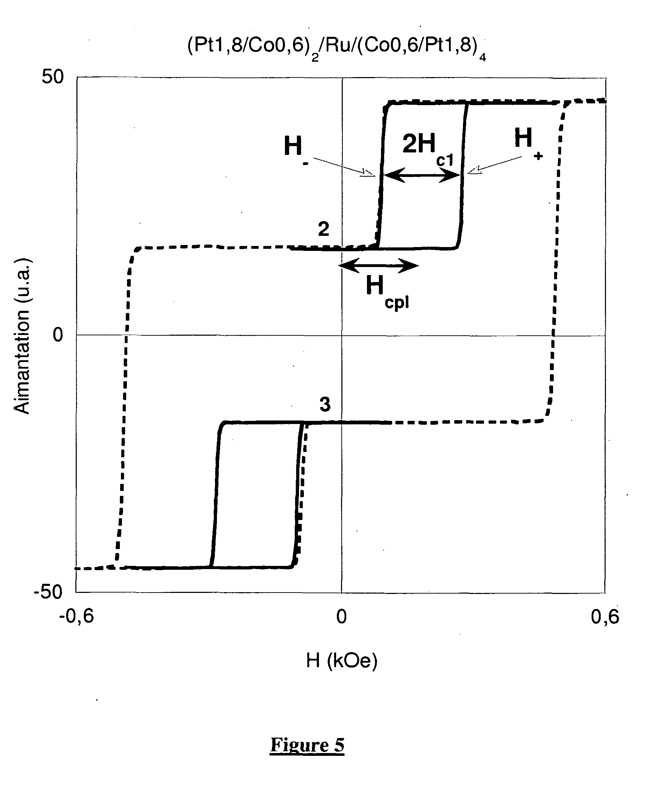

La figure 5 illustre les courbes d'aimantation que l'on peut observer dans ce cas pour un dispositif magnétique de grandes dimensions latérales. Ce dispositif magnétique est constitué d'un empilement de deux couches magnétiques semblables à celles qui constituent l'empilement décrit en relation avec la figure 2. En revanche, le matériau constitutif de la couche intercalaire non magnétique séparant ces multicouches magnétiques et son épaisseur sont sélectionnés de manière à induire un champ de couplage antiferromagnétique entre ces couches magnétiques, en l'occurrence une couche de ruthénium de 1 nm d'épaisseur.

L'empilement caractéristique de ce dispositif à couches magnétiques est donc constitué :

- d'une alternance de quatre couches de 1,8 nm de platine associées à quatre couches de 0,6 nm de cobalt,
- d'une couche non magnétique de 1 nm de ruthénium,
- d'une alternance de deux couches de 0,6 nm de cobalt associées à deux couches de 1,8 nm de platine.

Par ailleurs, si les dimensions latérales de ce dispositif magnétique sont suffisamment grandes, la somme du champ de couplage magnétostatique, dû au champ rayonné par les couches, et du champ de couplage ferromagnétique, induit par la rugosité d'interface, sera négligeable (plusieurs ordres de grandeur inférieure), comparée à la valeur du champ de couplage antiferromagnétique. Ceci entraînera un décalage de la courbe d'aimantation de la couche magnétique douce vers des valeurs positives du champ magnétique (trait continu sur la figure 5).

Ainsi, à l'inverse du cas présenté à la figure 4, les aimantations des deux couches magnétiques situées de part et d'autre de la couche intercalaire tendent à demeurer antiparallèles l'une à l'autre le plus longtemps possible, car cet état magnétique est favorisé par la prédominance du couplage antiferromagnétique. Le renversement de l'aimantation de la couche douce se produira alors pour un champ magnétique appliqué plus faible que dans le cas de la figure 2 (en fait la différence du champ coercitif $H_{cl}$ et du champ de couplage $H_{cpl}$).

Dans le cas où le dispositif magnétique ainsi structuré est mis en oeuvre pour former un support d'enregistrement à champ multi-coercitif, les états de stockage stables en champ nul sont, comme le montre la figure 5, les états haut-bas et bas-haut (points **2** et **3**), tandis que les états extrêmes haut-haut et bas-bas (points **1** et **4**) ne sont plus stables lorsque l'on soumet le dispositif magnétique à un champ d'excitation magnétique nul. Par analogie, et pour les applications de type "mémoires non volatiles" ou "portes logiques", le seul état stable en champ nul est alors, à l'inverse du cas mentionné en relation avec la figure 4, celui dans lequel les aimantations sont antiparallèles (état de haute résistance).

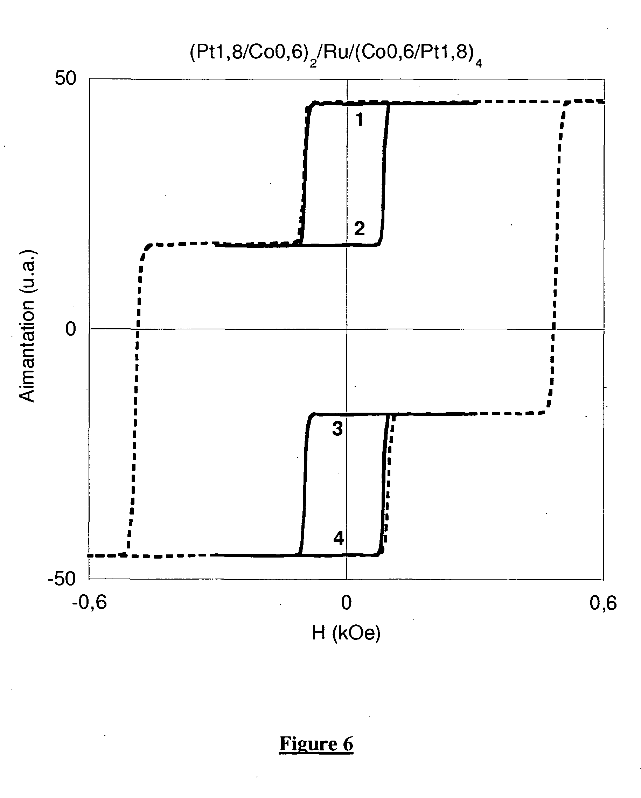

En revanche, le dispositif magnétique illustré par la figure 6, conforme à l'invention, présente quant à lui quatre états stables en champ magnétique nul. Sa structure d'empilement est semblable à celle du dispositif dont la figure 5 illustre le cycle d'hystérésis. Cependant, le dispositif magnétique illustré par la figure 6 présente des dimensions latérales réduites, conformément à une forme de réalisation de l'invention, si bien que les interactions magnétostatiques, en plus des interactions dues à la rugosité, induisent un champ de couplage ferromagnétique entre les structures multicouches magnétiques situées de part et d'autre de la couche intercalaire non magnétique.

Dans ce cas, les effets du champ de couplage antiferromagnétique dû à la couche intercalaire de ruthénium et les effets de ce champ de couplage ferromagnétique se compensent mutuellement, ce qui « recentre » le cycle d'aimantation de la couche magnétique douce. Par « recentrer », on désigne le déplacement du cycle d'hystérésis vers une position symétrique par rapport au champ magnétique nul ($H$ = 0 kOe).

En conséquence, les deux états extrêmes (points **1** et **4**) sont à nouveau stables en champ d'excitation magnétique nul. Les deux états intermédiaires (points **2** et **3**) demeurent quant à eux stables, si bien que ce dispositif magnétique présente quatre états stables (**1, 2, 3** et **4**) lorsqu'on ne le soumet à aucun champ d'excitation magnétique.

Pour les applications de type "mémoires non volatiles" ou "portes logiques", seuls importent les états dégénérés. On stabilise donc à nouveau, en champ magnétique nul, les deux états dégénérés (**1, 4**) et (**2, 3**), correspondant à des directions d'aimantation respectivement parallèles et antiparallèles des deux couches magnétiques.

Ainsi, un tel dispositif magnétique présente l'avantage d'être très compact et peu sensible aux perturbations magnétiques. De plus, l'aimantation des couches magnétiques étant perpendiculaire au plan des couches, il devient possible de miniaturiser le dispositif jusqu'à des dimensions inférieures aux dimensions limites potentielles des structures à aimantation planaire. En effet, dans le cas des couches à aimantation perpendiculaire, la limite superparamagnétique est repoussée vers les plus petites dimensions par rapport aux systèmes utilisant des couches à aimantation planaire.

Compte tenu de ces éléments, on peut relever qu'il est possible de réaliser une importante variété structurelle de dispositifs magnétiques conformément à l'invention. Le choix des caractéristiques du dispositif magnétique dépend alors de l'application recherchée et des performances souhaitées.

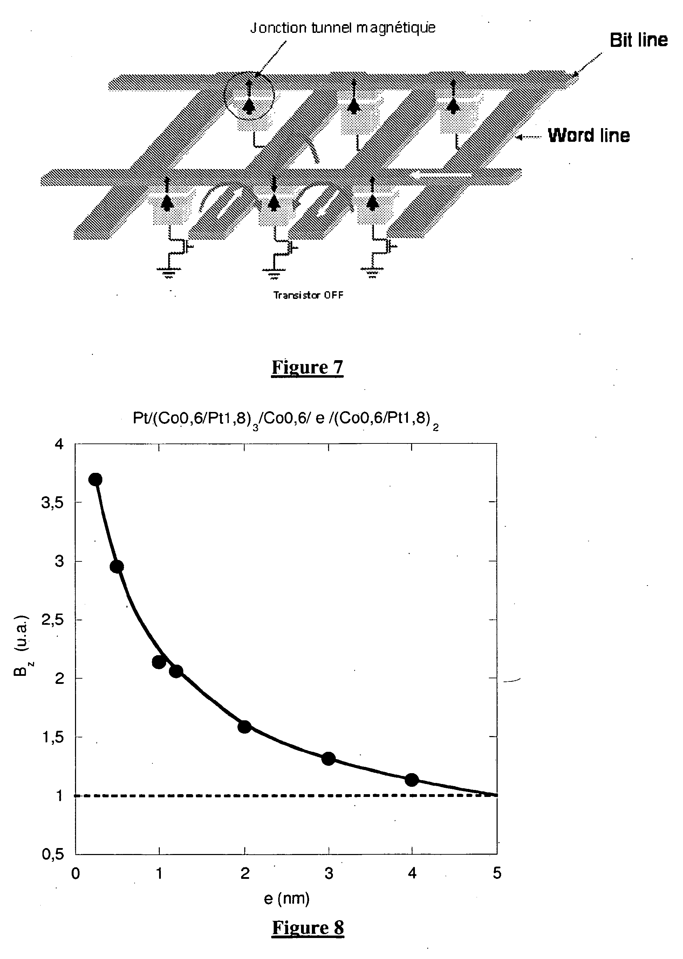

Ainsi par exemple, la figure 7 représente de façon schématique un ensemble de 6 cellules MRAM selon l'invention. Les jonctions tunnel magnétiques ont typiquement comme composition PtMn / Co / (Pt 1,5nm / Co 0,6nm)$_4$ / MgO 0,7nm / (Co 0.6nm /Pt 1,5nm)$_2$. Les aimantations des deux multicouches (Co/Pt) sont orientées perpendiculairement au plan des couches. L'épaisseur de la barrière d'oxyde MgO est choisie de sorte qu'un couplage antiparallèle existe entre les aimantations des deux multicouches magnétiques, couplage compensant le couplage magnétostatique entre ces deux multicouches.

L'aimantation de l'électrode inférieure (couche de référence) peut de façon avantageuse être piégée par une couche antiferromagnétique adjacente par exemple en PtMn. L'aimantation de la multicouche supérieure (couche de stockage) peut être orientée soit vers le haut, soit vers le bas. La jonction tunnel présente deux niveaux de résistance électrique différents suivant que les aimantations des deux multicouches sont parallèles ou antiparallèles (magnétorésistance tunnel).

L'écriture se fait en combinant trois impulsions de courant : 1) une impulsion de courant électrique dans la "bit line" située au dessus de la jonction adressée, laquelle impulsion génère un champ parallèle au plan des couches au niveau de la couche de stockage, 2) et 3) deux impulsions de courant de sens opposé dans les deux "word lines" situées de part et d'autre de la jonction pour générer un champ hors du plan, vers le haut ou vers le bas suivant le sens du courant dans ces deux lignes. Comme pour l'astroïde de Stoner-Wolfarth, la combinaison du champ planaire et du champ hors du plan permet de réaliser la sélectivité à l'écriture dans ce type de mémoires.

La lecture se fait en rendant passant le transistor de sélection connecté en série avec la jonction adressée. Le courant traversant la jonction permet d'en déterminer le niveau de résistance électrique et d'en déduire la configuration magnétique de la jonction.

Des expérimentations relativement aisées permettent de construire des abaques guidant le choix des paramètres (matériaux, épaisseurs et dimensions latérales) gouvernant la réalisation d'un dispositif magnétique conforme à l'invention.

Ainsi par exemple, le diagramme de la figure 8 montre, pour des plots cubiques de dimensions latérales de 100 nm par 100 nm, l'évolution du champ rayonné **B$_z$** (suivant la direction perpendiculaire au plan des couches) par la couche magnétique dure sur la couche magnétique douce en fonction de l'épaisseur **e** de la couche intercalaire non magnétique séparant les couches dure et douce.

En l'occurrence, le matériau constitutif de la couche intercalaire est du ruthénium et son épaisseur e varie de 0,2 nm à 5 nm. Comme le montre la courbe de la figure 7, le champ rayonné **B$_z$** entre couches, c'est-à-dire le champ de couplage ferromagnétique, augmente de façon approximativement hyperbolique lorsque l'on diminue l'épaisseur intercalaire **e**. Le champ rayonné est exprimé ici en unités arbitraires et il a été normalisé à une valeur de 1 pour une épaisseur de 5 nm.

De la même façon, on peut mesurer la variation de la valeur du champ de couplage indirect en fonction de l'épaisseur e de la couche intercalaire. Puis, en superposant les deux courbes obtenues, on peut déterminer l'épaisseur optimale pour laquelle les deux champs ferromagnétique et antiferromagnétique se compensent, annulant ainsi le couplage entre les couches magnétiques, qui deviennent alors magnétiquement indépendantes.

Les techniques de fabrication usuelles des empilements de couches magnétiques et non magnétiques peuvent être employées pour fabriquer un dispositif magnétique conforme à la présente invention. Ainsi, on peut employer la pulvérisation cathodique ou l'évaporation sous vide pour réaliser les dépôts des différentes couches. L'épitaxie peut également être employée pour faire croître certaines des couches composant les multicouches.

D'autres modes de réalisation de l'invention sont possibles sans pour autant sortir du cadre de cette invention.

## Revendications

1. Dispositif magnétique comportant au moins deux couches réalisées en matériau magnétique séparées par au moins une couche intercalaire en matériau non magnétique, lesdites couches en matériau magnétique présentant chacune une aimantation (M1,M2) orientée sensiblement perpendiculairement au plan desdites couches, et ladite couche en matériau non magnétique étant apte à induire un champ de couplage antiferromagnétique entre lesdites couches en matériau magnétique, *caractérisé :*

• **en ce que** le sens et l'amplitude du champ de couplage antiferromagnétique intervenant entre les couches magnétiques sont aptes à atténuer les effets du champ de couplage ferromagnétique d'origine magnétostatique qui s'exerce entre lesdites couches magnétiques,
• **en ce que** la couche intercalaire en matériau non magnétique est constituée d'un matériau choisi dans le groupe comprenant le ruthénium, le chrome, l'or, l'argent, le vanadium, le niobium, ou encore d'un alliage isolant choisi dans le groupe comprenant les oxydes de silicium, de magnésium, de zirconium, de titane, de tantale, de chrome, de ruthénium ou d'aluminium;
• et **en ce que** ladite couche intercalaire présente une épaisseur comprise entre 0,2 nm et 10 nm.

2. Dispositif magnétique selon la revendication 1, *caractérisé* **en ce que** ses dimensions latérales définies dans un plan parallèle au plan des couches sont inférieures à 10 $\mu$m.

3. Dispositif magnétique selon l'une des revendications 1 et 2, *caractérisé* **en ce que** la résultante desdits champs de couplage ferromagnétique et antiferromagnétique est plus faible que le champ coercitif de la couche magnétique la plus douce, ceci afin que les deux orientations relatives des aimantations des couches magnétiques, parallèle et antiparallèle, soient stables en l'absence de tout champ magnétique extérieur.

4. Dispositif magnétique selon l'une des revendications 1 et 2, *caractérisé* **en ce que** la résultante desdits champs de couplage ferromagnétique et antiferromagnétique est au moins dix fois plus faible que le champ coercitif de la couche magnétique la plus douce.

5. Dispositif magnétique selon l'une des revendications précédentes, *caractérisé* **en ce que** les couches en matériau magnétique sont composées, d'une part d'un élément pur, d'un alliage ou d'une pluralité de couches constitués d'un matériau choisi dans le groupe comprenant le fer, le cobalt et le nickel, et d'autre part d'un matériau choisi dans le groupe comprenant le platine, le palladium, le cuivre, ou d'un élément appartenant au groupe des terres rares ou au groupe des métaux de transition magnétique, de manière à présenter une aimantation orientée sensiblement perpendiculairement au plan des couches.

6. Dispositif magnétique selon l'une des revendications précédentes, *caractérisé* **en ce qu'**une couche supplémentaire est insérée entre la couche intercalaire et l'une au moins desdites couches en matériau magnétique, ladite couche étant constituée d'un matériau tel que le platine ou le palladium, apte à renforcer l'anisotropie magnétique perpendiculaire desdites couches en matériau magnétique.

7. Dispositif magnétique selon l'une des revendications précédentes, *caractérisé* **en ce que** les couches en matériau magnétique possèdent des aimantations totales différentes et des duretés magnétiques différentes de telle sorte que les aimantations rémanentes desdites couches en matériau magnétique présentent quatre états stables en champ d'excitation magnétique nul, respectivement haut-haut, haut-bas, bas-haut, bas-bas.

8. Dispositif magnétique selon la revendication 7, *caractérisé* **en ce que** ses couches successives sont constituées :

• d'une multicouche magnétique platine/cobalt de la forme générale $(Pt/Co)_n$,
• d'une couche non magnétique d'environ 1 nm de ruthénium,
• d'une multicouche magnétique cobalt/platine de la forme générale $(Co/Pt)_m$, les nombres de répétitions n et m étant différents.

9. Support d'enregistrement magnétique à champ multicoercitif, *caractérisé* **en ce qu'**il comprend un dispositif magnétique selon l'une des revendications 1 à 8.

10. Vanne de spin ou jonction tunnel magnétique, *caractérisée* **en ce qu'**elle comprend un dispositif magnétique selon l'une des revendications 1 à 8.

11. Mémoire magnétique à accès aléatoire, *caractérisée* **en ce qu'**elle comprend un dispositif magnétique selon la revendication 10.

12. Porte logique reprogrammable, *caractérisée* **en ce qu'**elle comprend un dispositif magnétique selon la revendication 10.

**Claims**

1. A magnetic device comprising a least two layers made of a magnetic material separated by at least one interlayer made of a non-magnetic material, each of said layers made of a magnetic material having magnetization oriented substantially perpendicular to the plane of said layers, and said layer made of a non-magnetic material being capable of inducing an antiferromagnetic coupling field between said layers made of a magnetic material, **characterized:**

> • **in that** the direction and amplitude of the antiferromagnetic coupling field occurring between the magnetic layers make it possible to attenuate the effects of the ferromagnetic coupling field of magnetostatic origin that occurs between said magnetic layers ;
> • **in that** said layer made of a non-magnetic material consists of a material selected from the group comprising ruthenium, chrome, gold, silver, vanadium, niobium or an insulating alloy selected from the group comprising silicon, magnesium, zirconium, titanium, tantalum, chrome, ruthenium or aluminum oxide and,
> • **in that** the interlayer has a thickness of 0.2 nm to 10 nm.

2. magnetic device as claimed in claim 1, **characterized in that** its lateral dimensions defined in a plane parallel to the plane of the layers are less than 10 $\mu$m.

3. A magnetic device as claimed in any of claims 1 and 2, **characterized in that** the resultant of said ferromagnetic and antiferromagnetic coupling fields is weaker than the weaker of the coercive fields of the layers made of magnetic materials in order that the two relative magnetization orientations of the magnetic layers parallel and antiparallel are stable in the absence of any external magnetic field.

4. A magnetic device as claimed in any of claims 1 and 2, **characterized in that** the resultant of said ferromagnetic and antiferromagnetic coupling fields is at least ten times weaker than the weaker of the coercive fields of the layers made of magnetic materials.

5. A magnetic device as claimed in any of the above claims, **characterized in that** the layers made of a magnetic material comprise, firstly, a pure element, an alloy or a plurality of layers consisting of a material selected from the group comprising iron, cobalt and nickel and, secondly, a material selected from the group comprising platinum, palladium, copper or an element belonging to the lanthanide series or magnetic transition metals group so as to obtain magnetization oriented substantially perpendicular to the plane of the layers.

6. A magnetic device as claimed in any of the above claims, **characterized in that** an additional layer is inserted between the interlayer and at least one of said layers made of a magnetic material, said layer consisting of a material such as platinum or palladium capable of enhancing the perpendicular magnetic anisotropy of said layers made of a magnetic material.

7. A magnetic device as claimed in one of the above claims, **characterized in that** the layers made of a magnetic material have different total magnetizations and different magnetic hardnesses so that the remanent magnetizations of said layers made of a magnetic material have four stable states in a zero excitation field, up-up, up-down, down-up and down-down respectively.

8. A magnetic device as claimed in claim 7, **characterized in that** its successive layers consist of:

> - a magnetic platinum/cobalt multilayer having the general form $(Pt/Co)_n$,
> - a non-magnetic approximately 1 nm ruthenium layer,
> - a magnetic cobalt/platinum multilayer having the general form $(Co/Pt)_m$, the number of repetitions n and m being different.

9. A multi-coercive field magnetic recording medium, **characterized in that** it comprises a magnetic device as claimed in any of claims 1 to 8.

10. A spin valve or magnetic tunnel junction, **characterized in that** it comprises a magnetic device as claimed in any of claims 1 to 8.

11. A random-access magnetic memory, **characterized in that** it comprises a magnetic device as claimed in claim 10.

12. A reprogrammable logic gate, **characterized in that** it comprises a magnetic device as claimed in claim 10.

**Patentansprüche**

1. Magnetvorrichtung, die mindestens zwei aus einem magnetischen Material hergestellte Schichten umfasst, die durch mindestens eine Zwischenschicht aus einem nicht magnetischen Material getrennt sind, wobei die Schichten aus magnetischem Material jeweils eine Magnetisierung (M1, M2) aufweisen, die im Wesentlichen senkrecht zur Ebene der Schichten ausgerichtet ist, und wobei die Schicht aus nichtmagnetischem Material ein Feld antiferromagnetischer Kopplung zwischen den Schichten aus magnetischem Material zu induzieren vermag, **dadurch gekennzeichnet:**

> • **dass** die Richtung und die Amplitude des Felds der antiferromagnetischen Kopplung, die zwischen den magnetischen Schichten auftritt, die Wirkungen des Felds der ferromagnetischen Kopplung magnetostatischen Ursprungs, die sich zwischen den magnetischen Schichten auswirkt, zu dämpfen vermögen,

• **dass** die Zwischenschicht aus nichtmagnetischem Material aus einem Material besteht, das aus der Gruppe ausgewählt ist, die Ruthenium, Chrom, Gold, Silber, Vanadium, Niob oder aber eine isolierende Legierung umfasst, die aus der Gruppe ausgewählt ist, die Silicium-, Magnesium-, Zirkon-, Titan-, Tantal-, Chrom-, Ruthenium- oder Aluminiumoxide umfasst;

• und **dass** die Zwischenschicht eine Dicke aufweist, die zwischen 0,2 nm und 10 nm beträgt.

2. Magnetvorrichtung nach Anspruch 1, **dadurch gekennzeichnet, dass** ihre in einer zur Ebene der Schichten parallelen Ebene definierten seitlichen Abmessungen kleiner als 10 $\mu$m sind.

3. Magnetvorrichtung nach einem der Ansprüche 1 und 2, **dadurch gekennzeichnet**, dans die Resultierende der Felder ferromagnetischer und antiferromagnetischer Kopplung schwächer ist als das Koerzitivfeld der weichsten magnetischen Schicht, und zwar, damit die beiden relativen Ausrichtungen der Magnetisierungen der magnetischen Schichten, die parallele und antiparallele Ausrichtung, in Abwesenheit jeglichen äußeren Magnetfelds stabil sind.

4. Magnetvorrichtung nach einem der Ansprüche 1 und 2, **dadurch gekennzeichnet, dass** die Resultierende der Felder ferromagnetischer und antiferromagnetischer Kopplung mindestens zehnmal schwächer ist als das Koerzitivfeld der weichsten magnetischen Schicht.

5. Magnetvorrichtung nach einem der vorhergehenden Ansprüche, **dadurch gekennzeichnet, dass** die Schichten aus magnetischem Material sich einerseits aus einem reinen Element, einer Legierung oder mehreren Schichten, die aus einem Material bestehen, das aus der Gruppe ausgewählt ist, die Eisen, Kobalt und Nickel umfasst, und andererseits aus einem Material, das aus der Gruppe ausgewählt ist, die Platin, Palladium, Kupfer umfasst, oder aus einem Element zusammensetzen, das zur Gruppe der seltenen Erden oder zur Gruppe der magnetischen Übergangsmetalle gehört, um eine zur Ebene der Schichten im Wesentlichen senkrecht ausgerichtete Magnetisierung aufzuweisen.

6. Magnetvorrichtung nach einem der vorhergehenden Ansprüche, **dadurch gekennzeichnet, dass** eine zusätzliche Schicht zwischen der Zwischenschicht und mindestens einer der Schichten aus magnetischem Material eingesetzt ist, wobei die Schicht aus einem Material wie etwa Platin oder Palladium besteht, das die senkrechte magnetische Anisotropie der Schichten aus magnetischem Material zu verstärken vermag.

7. Magnetvorrichtung nach einem der vorhergehenden Ansprüche, **dadurch gekennzeichnet, dass** die Schichten aus magnetischem Material unterschiedliche Gesamtmagnetisierungen und unterschiedliche magnetische Härten besitzen, so dass die remanenten Magnetisierungen der Schichten aus magnetischem Material vier stabile Zustände im magnetischen Erregungsfeld Null aufweisen, und zwar Hoch-Hoch, Hoch-Tief, Tief-Hoch, Tief-Tief.

8. Magnetvorrichtung nach Anspruch 7, **dadurch gekennzeichnet, dass** ihre aufeinanderfolgenden Schichten bestehen aus:

• einer magnetischen Mehrfachschicht aus Platin/Kobalt der allgemeinen Form $(Pt/Co)_n$,
• einer nichtmagnetischen Schicht aus ca. 1 nm Ruthenium,
• einer magnetischen Mehrfachschicht aus Kobalt/Platin der allgemeinen Form $(Co/Pt)_m$, wobei die Anzahlen an Wiederholungen n und m unterschiedlich sind.

9. Magnetischer Aufzeichnungsträger mit Multikoerzitivfeld, **dadurch gekennzeichnet, dass** er eine Magnetvorrichtung nach einem der Ansprüche 1 bis 8 umfasst.

10. Magnetisches Drehventil oder magnetischer Tunnelübergang, **dadurch gekennzeichnet, dass** dieses/dieser eine Magnetvorrichtung nach einem der Ansprüche 1 bis 8 umfasst.

11. Magnetspeicher mit Direktzugriff, **dadurch gekennzeichnet, dass** er eine Magnetvorrichtung nach Anspruch 10 umfasst.

12. Mehrfach programmierbares Logikgatter, **dadurch gekennzeichnet, dass** es eine Magnetvorrichtung nach Anspruch 10 umfasst.

**Figure 1a**

**Figure 1b**

$(Pt1,8/Co0,6)_2/Pt15/(Co0,6/Pt1,8)_4$

**Figure 2**

14

**Figure 3**

**Figure 4**

$(Pt1,8/Co0,6)_2/Ru/(Co0,6/Pt1,8)_4$

**Figure 5**

$(Pt1,8/Co0,6)_2/Ru/(Co0,6/Pt1,8)_4$

**Figure 6**

Jonction tunnel magnétique

Bit line

Word line

Transistor OFF

**Figure 7**

Pt/(Co0,6/Pt1,8)$_3$/Co0,6/ e /(Co0,6/Pt1,8)$_2$

**Figure 8**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6727105 B
- US 2004013880 A
- FR 2859306 A

**Littérature non-brevet citée dans la description**

- **S. S. P. PARKIN et al.** Systematic variation of the strength and oscillation period of indirect magnetic exchange coupling through the 3d, 4d, and 5d transition metals. *Physical Review Letters,* 1991, vol. 67, 3598-3601

- **J. FAURE-VINCENT et al.** Interlayer magnetic coupling interactions of two ferromagnetic layers by spin polarized tunneling. *Physical Review Letters,* 2002, vol. 89 (10), 107206